# EUROPEAN PATENT APPLICATION

(11) **EP 4 188 042 A1**
(43) Date of publication of application: **31.05.2023**
(21) Application number: 22208989.8
(22) Date of filing: 23.11.2022
(51) Int. Cl.: H05K 1/05

(54) **A PRINTED CIRCUIT BOARD WITH IMPROVED COOLING PROPERTIES AND METHOD FOR MANUFACTURE THEREOF**

(30) Priority: 26.11.2021 SE 2151443
(71) Applicant: Wivid AB, 931 33 Skelleftea (SE)
(72) Inventor: WIKSTRÖM, Erik, 931 33 Skellefteå (SE)
(74) Representative: Zacco Sweden AB

(57) **Abstract**

The present disclosure relates to a metal core printed circuit board, MCPCB, (100) with improved cooling properties. The MCPCB comprises a metal core (101). The MCPCB comprises further in a circuit area formed in a main plane of the MCPCB: a first metal core part (101a) of the metal core (101), a primary, electrically insulating layer (102) provided on said first metal core part (101a) of the metal core (101), an electrically conducting layer (103) with LED chips (104) provided on the primary, electrically insulating layer (102) and a solder mask (105) provided on the electrically conducting layer (103). The MCPCB comprises further in at least one non-circuit area without the conductive layer and solder mask, a second metal core part (101b) of the metal core (101), said at least one non-circuit area without the conductive layer and solder mask securing the improved cooling properties.

The present disclosure further relates to a method (900) for manufacture of a metal core printed circuit board, MCPCB, with improved cooling properties.

## Description

### TECHNICAL FIELD

The present disclosure relates to a printed circuit board comprising with cooling properties and a method for manufacture of said printed circuit board.

### BACKGROUND

Printed Circuit Boards, PCBs can have a plastic or metal core. Metal core printed circuit boards; MCPCBs, may for example be made of Aluminium or Copper. In order to handle the problem of cooling of PCBs, the heat generated by electrical components of the PCB is characteristically conducted away.

When a Metal Core Printed Circuit Board, MCPCB, is used, heat generated by electrical components of the MCPCB is characteristically conducted through the metal core to a cooler arranged below the MCPCB.

US 6 320 748 describes a solution for cooling, wherein a PCB has a cut-out that permits a monolithic copper or aluminium heatsink to be mounted flush with the PCB.

EP 1 508916 describes a solution for cooling semiconductor devices attached to a printed circuit board. A cooling member is in thermal contact with the semiconductor device, wherein a spring member provides a spring force forcing the semiconductor device against the cooling member.

### SUMMARY

The present disclosure relates to a PCB wherein cooling of electrical components of the PCB is obtained in an alternative way.

In accordance with the present disclosure, the PCB is a metal core printed circuit board, MCPCB with improved cooling properties. The MCPCB comprises a metal core. The MCPCB comprises further in a circuit area formed in a main plane of the MCPCB: a first metal core part of the metal core, a primary, electrically insulating layer provided on said first metal core part of the metal core, an electrically conducting layer with LED chips provided on the primary, electrically insulating layer and a solder mask -provided on the electrically conducting layer. The MCPCB comprises further in at least one non-circuit area without the conductive layer and solder mask, a second metal core part of the metal core (101). The at least one non-circuit area without the conductive layer and solder mask secures the improved cooling properties.

Thus, the metal core comprises at least one second part extending beyond the first part comprising the conductive layer/solder mask.

Thus, a first side of the MCPCB comprises the LED chips and a second side of the MCPCB comprises an outer surface of the metal core. Heat is transferred away from the MCPCB from the outer surface of the metal core via air and/or thermal transfer to other objects or materials.

The primary, electrically insulating layer may cover the entire metal core, i.e. both the circuit area and non-circuit area. The primary, electrically insulating layer may instead have the same extension as the electrically conducting layer and solder mask; i.e. the primary, electrically insulating layer may cover the circuit area. However, the metal core has an extension exceeding the extension of the circuit area with the conductive layer/solder mask.

The PCB in accordance with the present disclosure may avoid the need for a cooler.

Firstly, this is because a metal core printed circuit board, MCPCB is used.

Secondly, the size of the metal core conducting heat and thus cooling the MCPCB is bigger than the size of the sandwich structure of the MCPCB. The size of the metal core can be selected to be big enough to transport away the heat in any particular application.

Thirdly, heat is not transported away only from the second side of the MCPCB. At the non-circuit area of the MCPCB, corresponding to the second part of the metal core extending beyond the extension of the conductive layer/solder mask, heat can be transported away via both sides of the metal core. Heat can be transported away via the air or via other objects in thermal contact with the MCPCB. One or both sides of the second part of the metal core may be in thermal contact with such objects acting as coolers.

Optional features are disclosed in the dependent claims.

For example, at least a part of said at least one non-circuit area may be adapted for fitting into the system where the MCPCB is applied. For example, the at least one non-circuit area may extend in a direction or plane different from the main plane of the MCPCB or comprise protrusions.

Thereby, the metal core can be designed to fit into an available space.

In addition thereto or instead, least a part of said at least one non-circuit area may designed for improved airflow in the application where the MCPCB is implemented.

The present disclosure further relates to a system for cooling a MCPCB. The system comprising a MCPCB as defined above and at least one cooling component in thermal contact with at least one of the sides of the at least one second part (101b) of the metal core.

The present disclosure further relates to a method for manufacture of a printed circuit board with improved cooling properties.

### BRIEF DESCRIPTION OF THE DRAWINGS

Figure 1 illustrates schematically an example metal core printed circuit board with improved cooling properties in cross section.
Figure 2 illustrates schematically another example metal core printed circuit board with improved cooling properties in cross section.
Figure 3 illustrates a perspective view of the design of a metal core PCB according to a first example.
Figure 4 illustrates a perspective view of the design of a metal core PCB according to a second example.
Figure 5 illustrates a perspective view of the design of a metal core PCB according to a third example.
Figure 6 illustrates a perspective view of the design of a metal core PCB according to a fourth example.
Figure 7 illustrates a perspective view of the design of a metal core PCB according to a fifth example.
Figure 8 is a perspective view of an example metal core printed circuit board of a first part of a metal core.
Figure 9 illustrates a method for manufacture of a MCPCB with improved properties.

### DETAILED DESCRIPTION

A metal core printed circuit board, MCPCB, is a type of printed circuit board that has a metal material as its base or core. The metal material spreads heat from components on the MCPCB to the environment, thereby cooling components mounted on the MCPCB. The metal core is characteristically made of aluminum or copper. The metal core may be made of aluminum or copper alloy. The metal material covers one side of the MCPCB. The purpose of the core of an MCPCB is characteristically to redirect heat away from critical printed circuit board components to less crucial areas such as a metal heatsink backing or metallic core.

The MPCB extends in a main plane. The meal core is on one side provided with an electrically insulating layer. On top of the electrically insulating layer is a conductive layer provided. The conductive layer comprises a pattern of conductors, for example formed in copper, that provide electrical connections on that conductive layer. Further electrical components are mounted to the MCPCB and electrically connected to the electrical connections of the conductive layer. Further a solder mask is provided on top of the conductive layer, so that the conductive layer is embedded on the MCPCB.

The MCPCB may have a sandwich structure comprising a plurality of alternating conductive and insulating layers between the metal core and the electrical components/ solder mask..

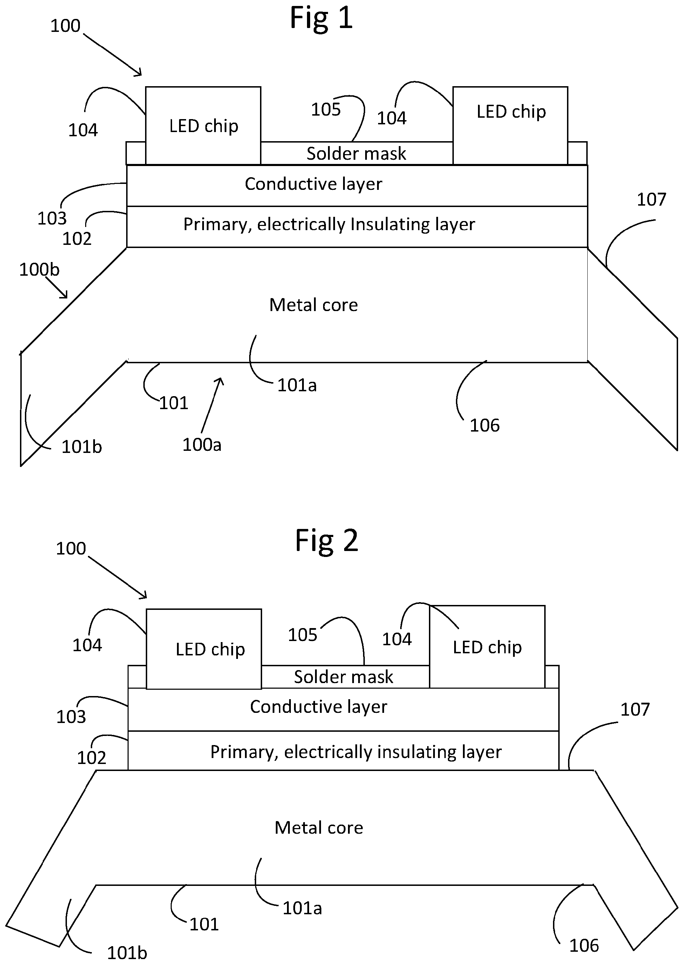

Figures 1 and 2 illustrate example PCBs 100 with improved cooling properties in cross section. The PCB is a metal core printed circuit board, MCPCB, and comprises a metal core 101. The metal core 101 is for example made of aluminum or copper or an aluminum or copper alloy. The thickness of the metal core is for example 1-2 mm, and preferably 1.3-1.5 mm.

The MCPCB comprises in a circuit area 100a formed in a main plane of the MCPCB,_a first metal core part 101a of the metal core 101, a primary, electrically insulating layer 102 provided on said first metal core part 101a of the metal core 101, an electrically conducting layer 103 with LED chips 104 provided on the primary, electrically insulating layer 102 and a solder mask 105 provided on the electrically conducting layer 103.

Thus, at least one primary, electrically insulating layer 102 is arranged on top of the metal core and a conductive layer 103 is arranged on top of the primary, electrically insulating layer 102. Thus, the primary, electrically insulating layer electrically insulates in the circuit area 100a of the MCPCB the printed circuits of the printed circuit board from the thermally and electrically conducting metal core. Thus, the insulation layer forms the dielectric material used to separate and isolate conducting elements and layers. The insulating material is often an epoxy-based prepreg.

The insulation layer is characteristically electrically insulating and convey heat poorly.

In the illustrated example only one primary, electrically insulating layer 102 and one conductive layer is disclosed, but the MCPCB may comprise a plurality of such alternating layers, wherein additional insulating layers are interposed between conductive layers. The insulating layers and conducting layers form a sandwich structure.

The conductive layer 103 comprises an electrically conducting pattern or paths of for example copper.

In multi-layer MCPCBs, the layers of material are laminated together in an alternating sandwich structure, as mentioned above. Primary electrically insulation layer, Copper, additional insulating layer, copper, additional insulating layer, copper, etc. are laminated together.

The metal core printed circuit board comprises at least one LED chip mounted at an outer surface of the conductive layer. The LED chips may comprise UVC LED chips.

The LED chips are generally mounted onto the MCPCB to both electrically connect and mechanically fasten them to the MCPCB.

The outer conducting layer 103 is as stated above provided with a solder mask 105.

The MCPCB comprises further in at least one non-circuit area 100b without the conductive layer and solder mask, a second metal core part 101b of the metal core 101, The at least one non-circuit area without the conductive layer and solder mask secures the improved cooling properties.

As explained above, the metal core 101 of the MCPCB 100 has a larger extension than at least some of the layers of the sandwich structure. In the illustrated examples of Figures 1 and 2, the metal core 101 comprises in the circuit area of the MCPCB the first part 101a facing an insulating layer102 of the sandwich structure. In at least one non-circuit area of the MCPCB, the MCPCB does not comprise the sandwich structure. In the illustrated example, 101b denotes at least one second part 101b of the metal core which extends beyond the extension of the sandwich structure.

The primary, electrically insulating layer may cover the entire metal core. The primary, electrically insulating layer may have the same extension as the electrically conducting layer and solder mask. The important thing is that the metal core has an extension exceeding the extension of the conductive layer/solder mask. Ideally, the primary, electrically insulating layer has the same extension as the electrically conducting layer and solder mask. However, as the primary, electrically insulating layer is generally thermally conductive, the thermally conductive properties are substantially maintained even when the primary, electrically insulating layer covers the entire metal core.

In accordance with the solution, the size of the metal core conducting heat and thus cooling the MCPCB is bigger than the size of the sandwich structure of the MCPCB. The size of the metal core can be selected to be big enough to transport away the heat in any particular application. Heat can be transported away via the air or via other objects in thermal contact with the MCPCB.

Heat is not transported away only from an outer side 106 of the MCPCB. In the non-circuit area of the MCPCB, wherein the metal core extends beyond the extension of the conductive layer/solder mask, heat can be transported away via both sides 106, 107 of the metal core. Heat can be transported away via the air or via other objects in thermal contact with the MCPCB. One or both sides 106, 107 of the second part of the metal core may be in thermal contact with such objects acting as coolers.

In the illustrated examples of Figures 1 and 2, at least a part of at least one non-circuit area 100b of the MCPCB extends in a direction or plane different from the main plane of the MCPCB. However, in an alternative example, the at least one non-circuit area 100b of the MCPCB extends in the same direction/plane as the circuit area 100a of the MCPCB.

In the example of Figure 1, the entire non-circuit area 100b of the MCPCB extends in a direction different from a plane in which the circuit area 100a extends.

In the alternative example of Figure 2, the non-circuit area 100b of the MCPCB extends partly in the same plane as the main plane part of the circuit area 100a of the MCPCB and partly extending in a direction different from the main plane.

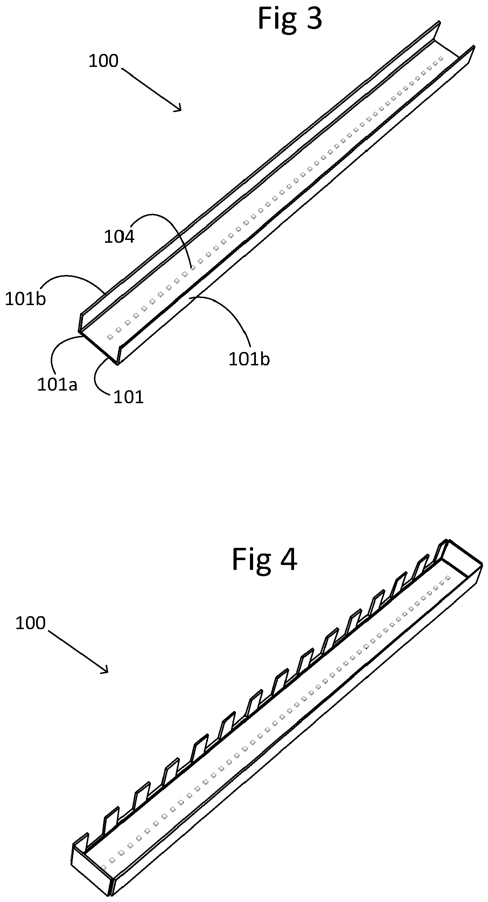

In figures 3 - 7, examples of a metal core printed circuit board 100 designs for example for MCPCBs as disclosed in relation to figure 1 or figure 2 are illustrated. The MCPCB comprises a metal core 101 comprises in a circuit area of the MCPCB a first part 101a facing one insulating layer of the sandwich structure. Further, the MCPCB comprises in a non-circuit area of the MCPCB at least one second part 101b of the metal core, said second part extending beyond the extension of the sandwich structure . At least a part of the non-circuit area of the MCPCB extends in a direction different from the main plane of the MCPCB.

In the example of figure 3, at least a part of the non-circuit area of the MCPCB extends in a plane different from the main plane of the MCPCB. Thus, at least a part of the non-circuit area of the MCPCB extends in a plane different for the main plane in which the first part of the MCPCB extends. In the illustrated specific example, the angle between the planes is 90°. Further, in the illustrated example, the at least one second part comprises two parts each extending along an extension of the MCPCB 100. However, this is only an example, second part(s) could for example be extending from the short end(s) of the MCPCB.

In the example of Figure 4, one of the second parts comprises protrusions.

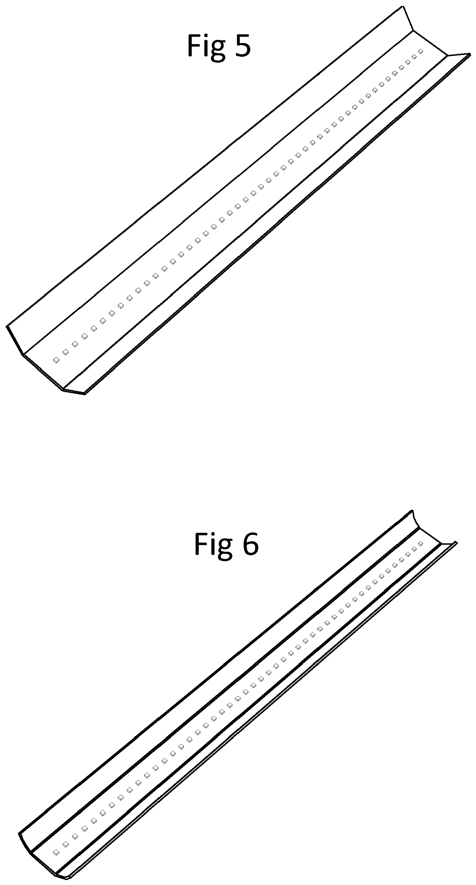

The example of Figure 5 corresponds to the example of Fig 3, with the difference that the angle between the planes is different from 90°.

In the example of figure 6, at least a part of the at least one second part form a convex surface.

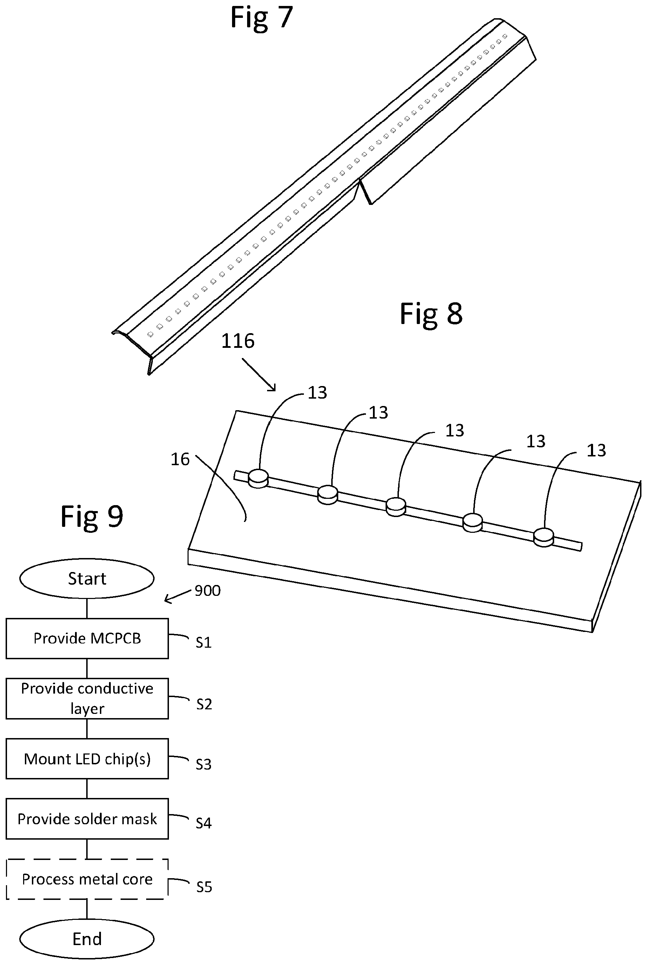

Figure 7 illustrates the flexibility of the design. The design of the second part of the MCPCB can be selected in any way to fit into available space.

Figure 8 illustrates an example wherein a radiation source 116 comprises a first part 101a of a metal core printed circuit board or chip 16 with a plurality of UVC LEDs 13 mounted thereon. The driver circuit of the radiation source 116 is not shown in this figure.

In figure 9, a method 900 of manufacture of a metal core printed circuit board, MCPCB, with improved cooling properties comprising a step of providing S1 a metal core printed circuit board, MCPCB.

A conductive layer with electrically conducting paths is provided S2 on the MCPCB, wherein a primary, electrically insulating layer is interposed between the conductive layer and a core of the MCPCB, and wherein the conductive layer extends only along a part of the metal core of the MCPCB,

At least one LED chip is mounted S3 at the MCPCB, and a solder mask is provided S4 to isolate the conductive paths of the MCPCB.

The metal core may then be processed S5 by bending or roll forming or pressing the metal core at at least one part not provided with the conductive layer. The at least one part not provided with the conductive layer may either be covered with the primary, electrically insulating layer or not.

## Claims

1. A metal core printed circuit board, MCPCB, (100) with improved cooling properties, said MCPCB_comprising a metal core (101), said MCPCB further comprising in a circuit area formed in a main plane of the MCPCB,_
a first metal core part (101a) of the metal core (101),
a primary, electrically insulating layer (102) provided on said first metal core part (101a) of the metal core (101),
an electrically conducting layer (103) with LED chips (104) provided on the primary, electrically insulating layer (102) and
a solder mask (105) provided on the electrically conducting layer(103),
**characterized in that** the MCPCB comprises further in at least one non-circuit area without the conductive layer and solder mask, a second metal core part (101b) of the metal core (101), said at least one non-circuit area without the conductive layer and solder mask securing the improved cooling properties.

2. The metal core printed circuit board according to claim 1, wherein at least a part of said at least one non-circuit area extends in a direction different from the main plane of the MCPCB.

3. The printed circuit board according to claim 2, wherein at least a part of said at least one non-circuit area extends in a plane different from the main plane of the MCPCB.

4. The printed circuit board according to claim 2 or 3, wherein at least a part of said at least one non-circuit area forming a convex surface.

5. The printed circuit board according to any of the preceding claims, wherein the at least one second part (101b) of the metal core (101) comprises protrusions.

6. The printed circuit board according to any of the preceding claims, wherein at least a part of said at least one non-circuit area is shaped for improved airflow.

7. The printed circuit board according to any of the preceding claims, wherein the at least one LED chip comprises at least one UVC LED chip.

8. The printed circuit board according to any of the preceding claims, wherein the metal core (101) comprises Aluminium or Copper.

9. A system for cooling a MCPCB, said system comprising
a MCPCB according to any of the preceding claims and
at least one cooling component in thermal contact with at least one of the sides of the at least one second part (101b) of the metal core.

10. A method (900) for manufacture of a metal core printed circuit board, MCPCB, with improved cooling properties comprising the steps of
- providing (S1) a metal core printed circuit board, MCPCB,
- provide (S2) a conductive layer with electrically conducting paths on the MCPCB, wherein a primary, electrically insulating layer is interposed between the conductive layer and a core of the MCPCB, wherein the conductive layer extends only along a part of the metal core of the MCPCB,
- mounting (S3) at least one LED chip at MCPCB , and
- providing (S4) a solder mask to isolate the conductive paths of the MCPCB.

11. The method according to claim 10, further comprising a step of processing (S5) the metal core, said processing involving bending or roll forming or pressing the metal core at at least one part not provided with the conductive layer and solder mask
